# DEMANDE DE BREVET EUROPEEN

(11) **EP 0 918 452 A1**
(43) Date de publication de la demande: **26.05.1999**
(21) Numéro de dépôt: 98402935.5
(22) Date de dépôt: 16.11.1998
(51) Int. Cl.: H05K 7/20

(54) **Variateur électronique de vitesse**

(30) Priorité: 21.11.1997 FR 9714884
(71) Demandeur: SCHNEIDER ELECTRIC SA, 92100 Boulogne Billancourt (FR)
(72) Inventeur: Gaudrel, Lionel, 78500 Mantes La Jolie (FR); Gaudet, Francois, 78200 Magnanville (FR); Guigueno, Hervé, 94100 Saint Maur des Fosses (FR)

(57) **Abrégé**

La présente invention concerne un variateur électronique de vitesse comprenant un radiateur (13) constituant le fond du coffret de variateur (1) et servant à fixer des composants émettant de la chaleur tels que des condensateurs (9), essentiellement caractérisé par le fait que le radiateur (1) est constitué par une semelle plane et s'accouple par sa face arrière plane (132) à un radiateur à ailettes (3) qui se fixe de manière démontable.

## Description

La présente invention se rapporte à un variateur électronique de vitesse comprenant un radiateur constituant le fond du boîtier et servant à fixer, côté interne, des composants émettant de la chaleur tels que des condensateurs.

Les variateurs de vitesse qui servent à contrôler la vitesse des moteurs comprennent des condensateurs et des modules de puissance qui génèrent de la chaleur que l'on évacue à l'arrière du boîtier par un radiateur de chaleur.

On a proposé dans le document EP 660 652 de réaliser un variateur composé d'une partie arrière contenant l'équipement de refroidissement et d'une partie avant contenant l'électronique de manière à pouvoir déporter les parties chauffantes à l'extérieur d'une enveloppe étanche. Pour monter ce variateur sur une armoire, il faut découper une ouverture rectangulaire dans la paroi de cette armoire, les deux parties montées de part et d'autre de la paroi étant réunies l'une à l'autre par des vis.

La présente invention a pour but de fournir un variateur de vitesse équipé d'un premier radiateur constituant le fond du boîtier et d'un second radiateur à ailettes qui est susceptible d'être accolé au premier radiateur de manière démontable et séparable du variateur. On peut monter le radiateur à ailettes à l'extérieur d'une armoire et le variateur à l'intérieur, ceci sans démonter le variateur et sans avoir à découper la paroi de cette armoire. Ce radiateur à ailettes peut également constituer un fond de boîtier d'un ensemble départ-moteur et servir au montage des différents composants du départ-moteur.

Le variateur électronique de vitesse selon l'invention est caractérisé par le fait que le radiateur est constitué par une semelle plane et s'accouple par sa face arrière plane à un radiateur à ailettes qui se fixe de manière démontable.

Selon une caractéristique. le variateur comporte entre la semelle et la radiateur à ailettes, une feuille mince flexible conduisant la chaleur.

Selon une caractéristique, la semelle plane est accolée à la paroi d'une armoire électrique, du côté intérieur, et le radiateur à ailettes est accolé à ladite paroi, du côté extérieur.

Selon une caractéristique, le radiateur à ailettes est de plus grandes dimensions que la semelle et constitue le fond d'un coffret de départ moteur sur lequel sont fixés, en plus du variateur, d'autres appareils électriques.

L'invention va maintenant être décrite avec plus de détail en se référant à des modes de réalisation donnés à titre d'exemples et représentés par les dessins annexés sur lesquels:

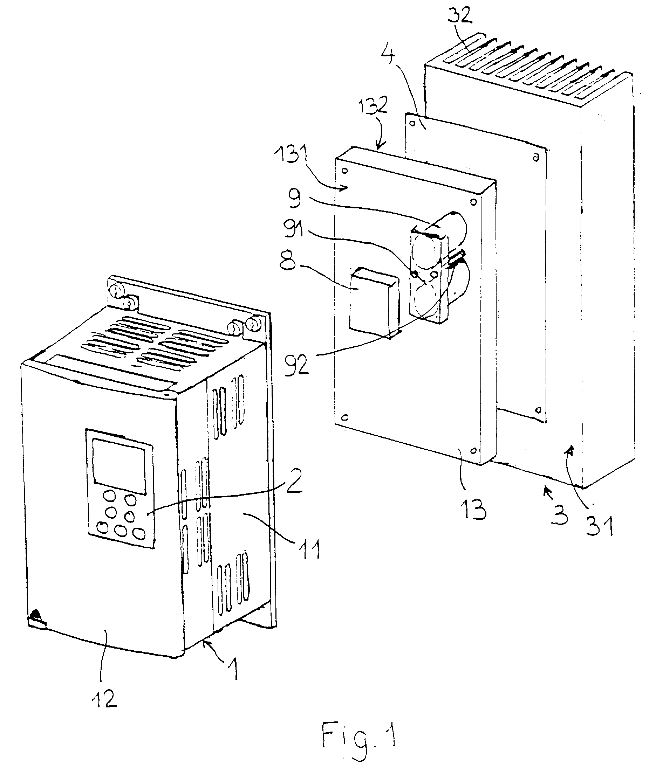

- la figure 1 est une vue en perspective éclatée du variateur à double radiateur selon l'invention;
- la figure 2 est une vue montrant le variateur monté dans une armoire électrique;
- la figure 3 est une vue éclatée montrant le variateur dans un ensemble constituant un départ-moteur.

Le variateur électronique de vitesse représenté sur les dessins est enveloppé dans un coffret 1 constitué par un cadre de coffret 11 fermé, à l'avant, par un couvercle 12 et, à l'arrière, par un radiateur plat 13.

Le couvercle 12 est monté pivotant sur le cadre de coffret 11 à l'aide de charnières latérales et se verrouille sur le corps de coffret à l'aide d'une serrure. Le cadre de coffret 1 se fixe sur un support à l'aide de pattes de fixation 111 fixées à l'arrière. Le côté inférieur du coffret permet le passage des câbles. Les côtés du cadre de coffret présentent des ouïes d'aération.

Le coffret 1 contient un redresseur à diodes relié au réseau et alimentant, par des condensateurs de filtrage 9, un onduleur relié au moteur. L'onduleur est équipé de modules de puissance 8 pourvus d'interrupteurs électroniques statiques de puissance associés à des diodes de récupération.

Les modules de puissance 8 et les condensateurs 9 sont montés sur la face interne 131 d'une semelle plane 13 ayant la forme d'une plaque épaisse et avantageusement réalisée en aluminium ou alliage d'aluminium de manière à conduire la chaleur. La face externe plane 132 de la semelle 13 sert à l'évacuation de la chaleur. Les condensateurs 9 sont pressés contre la semelle par une bride 91 fixée à la semelle 13 par des colonnes 92.

Le coffret contient un ensemble électronique de commande qui pilote les interrupteurs statiques des modules de puissance.

Le coffret 1 contient un capot de protection en plastique isolant qui cache et protège, lorsqu'on ouvre le couvercle 12, l'électronique contenue dans le boîtier. Ce capot de protection ferme en grande partie le corps de coffret. Il apparaît dès que l'on ouvre le couvercle 12 et protège l'opérateur contre les chocs électriques. Il porte une console de dialogue 2 qui affleure dans une découpe du couvercle lorsque celui-ci est fermé.

Le radiateur plat 13 qui constitue le fond du coffret coopère avec un radiateur à ailettes 3 qui est susceptible d'être accolé au premier radiateur mais est démontable et séparable du variateur. Ce radiateur à ailettes 3 présente, d'un côté, une face plane 31 venant au contact de la face arrière 132 du radiateur plat 13 et, de l'autre côté. des ailettes de refroidissement 32.

Le contact entre le radiateur plat 13 et le radiateur à ailettes 3 s'effectue par l'intermédiaire d'une feuille thermique 4, mince et flexible, qui assure la conduction thermique entre la semelle 13 et le radiateur 32 tout en assurant l'isolation électrique. Cette feuille thermique peut, par exemple, être constituée par une feuille métallique revêtue, sur ses deux faces, par une couche d'isolant électrique ou par une feuille de carbone revêtue, sur ses deux faces, par un élastomère.

Le coffret 11 comporte sur son côté supérieur, au dessus des ouïes de ventilation, un écran en plastique qui évite l'introduction de particules métalliques ou de poussières conductrices en chute verticale tout en garantissant une protection des personnes et en permettant la dissipation thermique des éléments chauffants internes du variateur. Cet écran ménage un canal d'aération au dessus des ouïes de ventilation de manière à permettre la circulation d'air tout en empêchant le passage de particules.

Dans le montage illustré à la figure 2, le variateur est monté à l'intérieur d'une armoire électrique 5 de manière que la semelle 13 soit plaquée contre la face interne de la paroi 51 de cette armoire, deux feuilles intercalaires thermiques 4 étant interposées de part et d'autre de la paroi. Le radiateur à ailettes 3 est monté à l'extérieur de la paroi 51 de l'armoire et en vis à vis de la semelle plane 13. La conducteur thermique s'effectue au travers de la paroi 51 qui est métallique. Le variateur 1 est monté à l'intérieur de l'armoire sans aucun démontage et sans avoir à découper la paroi de l'armoire. La seule opération à faire est de percer quatre trous dans la paroi de l'armoire pour passer les vis réunissant le radiateur à ailettes 3 au variateur.

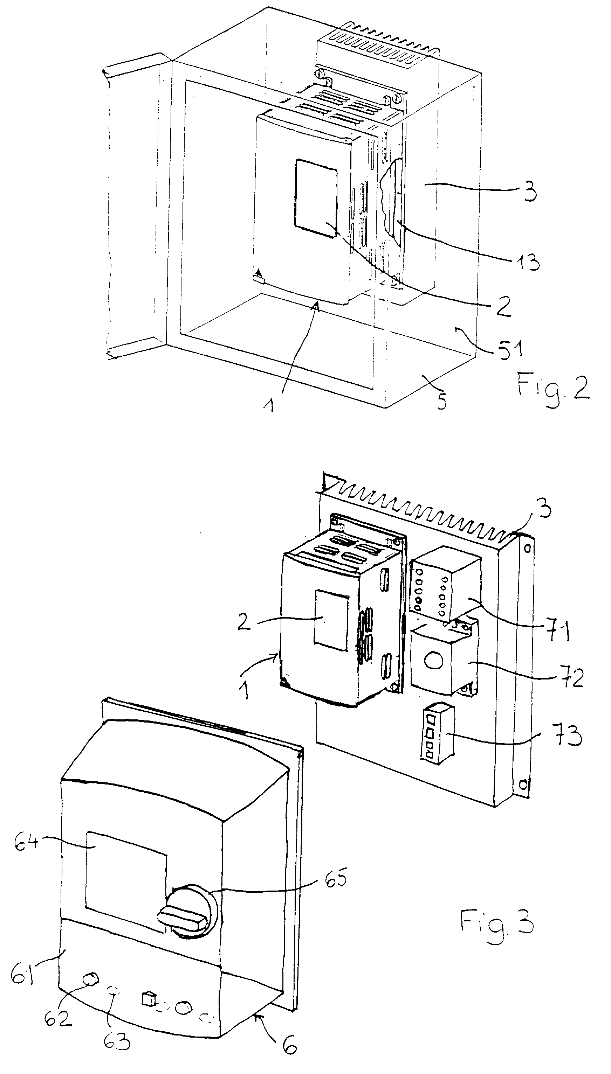

Dans le montage illustré à la figure 3, le radiateur à ailettes 3 a de plus grandes dimensions que la semelle plane 13 et constitue le fond d'un coffret 6 contenant un départ-moteur. Ce radiateur à ailettes 3 sert au montage des différents composants du départ-moteur, en particulier du variateur de vitesse 1 mais aussi d'un contacteur 71, d'un disjoncteur-moteur 72 et d'un connecteur 73. Le coffret 6 présente une couvercle mobile 64 servant à atteindre la console de dialogue 2 et un couvercle amovible 61 portant des unités de dialogue 62 et des passages 63 pour des câbles. Un bouton de commande 65 sert à commander le disjoncteur-moteur.

Il est bien entendu que l'on peut sans sortir du cadre de l'invention imaginer des variantes et des perfectionnements de détail et de même envisager l'emploi de moyens équivalents.

## Revendications

1. Variateur électronique de vitesse comprenant un radiateur (13) constituant le fond du coffret de variateur (1) et servant à fixer des composants émettant de la chaleur tels que des condensateurs (9), caractérisé par le fait que le radiateur (1) est constitué par une semelle plane et s'accouple par sa face arrière plane (132) à un radiateur à ailettes (3) qui se fixe de manière démontable.

2. Variateur selon la revendication 1, caractérisé par le fait qu'il comporte. entre la semelle plane (13) et le radiateur à ailettes (3), une feuille thermique (4), mince et flexible, conduisant la chaleur.

3. Variateur selon l'une quelconque des revendications précédentes. caractérisé par le fait que la semelle plane (13) est accolée à la paroi (51) d'une armoire électrique, du côté intérieur. et que le radiateur à ailettes (3) est accolé à ladite paroi, du côté extérieur.

4. Variateur selon la revendication 3, caractérisé par le fait qu'il comporte deux feuilles intercalaires thermiques (4) interposées de part et d'autre de la paroi (51).

5. Variateur selon l'une quelconque des revendications précédentes. caractérisé par le fait que le radiateur à ailettes (3) a de plus grandes dimensions que la semelle plane (13) et constitue le fond d'un coffret de départ moteur sur lequel sont fixés, en plus du variateur (1), d'autres appareils électriques (71, 72, 73).
